# DEMANDE DE BREVET EUROPEEN

(11) **EP 2 680 311 A1**
(43) Date de publication de la demande: **01.01.2014**
(21) Numéro de dépôt: 13173334.7
(22) Date de dépôt: 24.06.2013
(51) Int. Cl.: H01L 29/739, H01L 29/08, H01L 21/331, H01L 29/51, H01L 29/165

(54) **Transistor à effet tunnel**

(30) Priorité: 25.06.2012 FR 1255979
(71) Demandeur: Commissariat à l'Énergie Atomique et aux Énergies Alternatives, 75015 Paris (FR)
(72) Inventeur: Le Royer, Cyrille, 38210 Tullins-Fures (FR); Anghel, Costin, 92170 Vanves (FR)
(74) Mandataire: Lebkiri, Alexandre

(57) **Abrégé**

La présente invention concerne un transistor à effet tunnel comportant un canal (101) intrinsèque, des régions d'extension de source (102) et de drain (103) de types de conductivité respectifs opposés de part et d'autre dudit canal (101), des régions conductrices de source (104) et de drain (105), une structure de grille (106) surmontant le canal (101), une extrémité (109) du canal n'étant pas recouverte par celle-ci. Le transistor comporte des moyens (111) pour former un espace isolant de source entre les flancs respectifs de la structure de grille (106) et la région conductrice de source (104) en regard l'un de l'autre, lesdits moyens comportant un premier (112) et un deuxième (113) espaceurs diélectriques. La région d'extension de source (102) possède une épaisseur strictement (t_{S}) supérieure à celle (t_{Si}) du canal (101) de sorte que la région d'extension de source (102) présente une surépaisseur (118) en regard de la couche diélectrique (108) de grille. La première face (116) du premier espaceur (112) est au contact du flanc de la zone de grille (107) suivi du flanc de la couche diélectrique (108) de grille de sorte que la première face (116) recouvre l'intégralité du flanc de la couche diélectrique (108). Le premier espaceur (112) recouvre la surface supérieure de l'extrémité (109) du canal (101) non recouverte par la structure de grille (106) et présente une longueur (l) strictement inférieure à 5nm.

## Description

La présente invention concerne le domaine de la microélectronique et a plus particulièrement pour objet un transistor à effet tunnel.

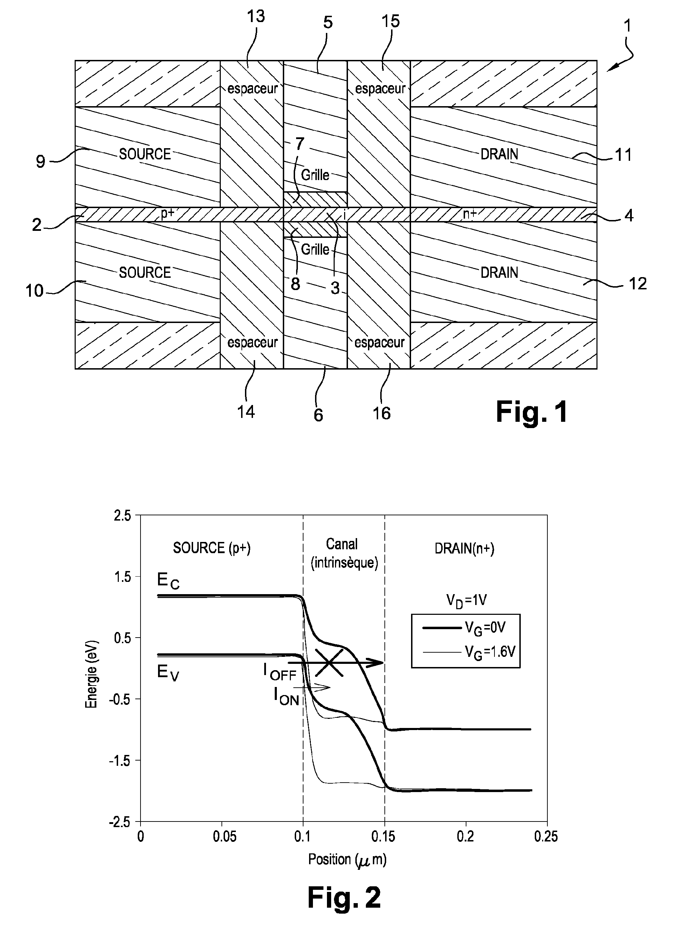

De manière générale, les transistors à effet tunnel TFET (« Tunnel Field Effect Transistor » en langue anglaise) sont de plus en plus envisagés pour remplacer les transistors de type CMOS, notamment pour des applications à faible puissance. Les transistors à effet tunnel (dit également à jonction tunnel) sont des diodes PiN à grille où le courant à l'état passant provient de porteurs passant de bande à bande par effet tunnel. Ils sont des dispositifs intéressants pour des applications à faible consommation de puissance. Les transistors TFET présentent en effet des courants de fuite I_{off} (courant à l'état bloqué du transistor) très bas ainsi que des pentes sous seuil (« subthreshold slope » en langue anglaise) élevées comparés à des transistors CMOS de dimension similaire. Un exemple de structure d'un transistor TFET 1 de type N à double grille est illustré en figure 1. Le TFET 1 est basé sur une architecture de diode PiN avec une grille et comporte :
- une zone semi-conductrice 2 de source dopée p+ ;
- une zone semi-conductrice 3 de canal central intrinsèque ;
- une zone semi-conductrice 4 de drain dopée n+ ;
- deux zones de grille 5 et 6, par exemple métallique, au-dessus et au-dessous de la zone intrinsèque 3 et séparées de celle-ci par une couche diélectrique de grille (respectivement 7 et 8).

Le matériau diélectrique de la couche diélectrique de grille est le plus souvent un matériau à forte constante diélectrique, dit matériau « high-k » ; un tel matériau permet notamment d'obtenir de meilleurs courants de conduction.

On trouve de part et d'autre de la zone de source 2 des zones conductrices de source 9 et 10 (par exemple en NiSi) réalisées par exemple par siliciuration.

De même, on trouve de part et d'autre de la zone de drain 4 des zones conductrices de drain 11 et 12 (par exemple en NiSi) réalisées par exemple par siliciuration.

Les zones conductrices de source 9 et 10 sont respectivement isolées des zones de grille 5 et 6 (et de leur couche diélectrique associée) par des espaceurs 13 et 14.

Les zones conductrices de drain 11 et 12 sont respectivement isolées des zones de grille 5 et 6 (et de leur couche diélectrique associée) par des espaceurs 15 et 16.

La figure 2 illustre les diagrammes de bande du dispositif 1 en fonction de la position le long du dispositif 1 et selon les tensions appliquées à la grille, au drain et à la source.

Le principe de fonctionnement est le suivant : en appliquant une tension positive au niveau du drain (ici VD=1 V), on polarise la diode PiN en inverse créant ainsi une barrière de potentiel de sorte qu'on obtient un très faible courant I_{off} en mode bloqué. En appliquant une tension de grille positive (ici VG=1.6V), on augmente la probabilité de transition tunnel du côté de la source en rapprochant les bandes de valence et de conduction. Le transport est ensuite assuré par le champ électrique source/drain.

Comme mentionné plus haut, un des avantages du transistor TFET est qu'il offre un courant de fuite I_{off} très faible comparé à un transistor CMOS (et donc une puissance dissipée réduite en mode bloqué).

L'une des problèmes majeurs des transistors TFET réside toutefois dans la faible intensité de courant de conduction Iₒₙ (i.e. courant à l'état passant du transistor) comparée aux valeurs de Iₒₙ obtenues pour des transistors CMOS de dimension similaire.

Une solution connue à ce problème est présentée dans le document « Tunnel field effect transistor with increased ON current, low-k spacer and hick-k dielectric » (Anghel et al., Applied Physics Letters 96, 122104 (2010)). Cette solution consiste à remplacer les matériaux high-k des espaceurs 13, 14, 15 et 16 par des matériaux à plus faible constante diélectrique, dits matériaux low-k. Le fait d'utiliser un matériau high-k pour le matériau diélectrique de grille et un matériau low-k pour les espaceurs permet d'augmenter sensiblement le courant de conduction Iₒₙ et la pente sous seuil.

Une seconde solution connue à ce problème est présentée dans le document « Impact of SOI, Si₁₋ₓGeₓOI and GeOI substrates on CMOS compatible Tunnel FET performance » (Mayer et al. - Tech. Dig.-Int. Electron Devices Meet. - 2008). La figure 3 illustre une structure de transistor TFET 20 conforme à ce document. Le transistor 20 est un transistor simple grille. Il est réalisé sur un substrat de type SOI (« Silicium On Insulator ») 21 et comporte :
- une zone semi-conductrice 22 de source dopée p+ ;
- une zone semi-conductrice 23 de canal central intrinsèque ;
- une zone semi-conductrice 24 de drain dopée n+ ;
- une zone de grille 25 surmontant la zone intrinsèque 23 et séparées de celle-ci par une couche diélectrique de grille 26.

La zone semi-conductrice de source 22 est isolée de la zone de grille 25 par un premier et un deuxième espaceurs 27 et 28. Le premier espaceur 27 s'étend sur une longueur (mesurée suivant le sens longitudinal du canal du transistor) d'environ 10nm tandis que le deuxième espaceur 28 s'étend sur une longueur de 15 ou 30nm. Le premier espaceur 27 est localisé sur toute la hauteur de la zone de grille 25 et s'arrête à la surface supérieure de la couche diélectrique de grille 26. Le second espaceur 28 est localisé côté source entre le premier espaceur 27 et la zone de source 22 sur une partie de la hauteur de la zone de grille 25. Le transistor 20 présente un courant Iₒₙ plus important pour une longueur du second espaceur 28 égale à 30nm que pour une longueur de 15nm.

Malgré les résultats mentionnés ci-dessus, les transistors à effet tunnel continuent à présenter des courants Iₒₙ de conduction insuffisants.

Dans ce contexte, la présente invention a pour but de fournir un transistor à effet tunnel présentant des caractéristiques améliorées notamment en termes de courant de conduction et de pente sous le seuil.

A cette fin, la présente invention a pour but de fournir un transistor à effet tunnel comportant :
- un canal réalisé dans un matériau semi-conducteur intrinsèque ;
- des régions d'extension de source et de drain de part et d'autre dudit canal, en contact avec le matériau semi-conducteur intrinsèque dudit canal, ladite région d'extension de source étant réalisée dans un matériau semi-conducteur dopé selon un premier type de dopage P ou N et ladite région d'extension de drain étant réalisée dans un matériau semi-conducteur dopé selon un second type de dopage inverse dudit premier type de dopage ;

- des régions conductrices de source et de drain respectivement en contact avec les régions d'extension de source et de drain et s'étendant respectivement au-dessus des régions d'extension de source et de drain ;
- une structure de grille surmontant ledit canal et agencée de sorte qu'une extrémité dudit canal n'est pas recouverte par la structure de grille du côté de la région d'extension de source, ladite structure de grille comportant :
   ○ une couche diélectrique de grille en contact avec ledit canal ;
   ○ une zone de grille au-dessus de ladite couche diélectrique de grille de sorte que ladite couche diélectrique de grille est disposée entre ladite zone de grille et ledit canal ;
- des moyens pour former un espace isolant de drain entre les flancs respectifs de ladite structure de grille et de ladite région conductrice de drain en regard l'un de l'autre ;
- des moyens pour former un espace isolant de source entre les flancs respectifs de ladite structure de grille et ladite région conductrice de source en regard l'un de l'autre, lesdits moyens comportant un premier et un deuxième espaceur diélectriques présentant chacun une première et une deuxième face latérale ;
ledit transistor étant **caractérisé en ce que** :
- ladite région d'extension de source possède une épaisseur strictement supérieure à celle du canal de sorte que ladite région d'extension de source présente une surépaisseur en regard de ladite couche diélectrique de grille ;
- la première face dudit premier espaceur est au contact du flanc de ladite zone de grille suivi du flanc de ladite couche diélectrique de grille de sorte que ladite première face recouvre l'intégralité du flanc de ladite couche diélectrique ;
- la deuxième face dudit premier espaceur est au contact de la première face dudit deuxième espaceur et se prolonge le long du flanc de la surépaisseur de la région d'extension de source ;
- le premier espaceur recouvre la surface supérieure de l'extrémité dudit canal non recouverte par la structure de grille et présente une longueur strictement inférieure à 5nm, ladite longueur étant mesurée selon la direction longitudinale dudit canal.

Grâce à l'invention, le fait d'utiliser une zone d'extension de source dopée P (cas d'un TFET de type N) ou N (cas d'un TFET de type P) présentant une épaisseur plus importante que celle du canal combiné à l'utilisation d'un premier espaceur présentant une faible longueur (i.e. moins de 5 nm) entre la surépaisseur de la zone d'extension de source et le diélectrique de grille permet d'augmenter considérablement le courant Iₒₙ de conduction et d'avoir des performances sous seuil améliorées. Le déposant a ainsi constaté que la présence des caractéristiques ci-dessus permet de limiter la déplétion au niveau de l'interface entre le canal et la zone d'extension de source et donc d'augmenter le courant de conduction. Le fait que le deuxième espaceur vienne recouvrir l'extrémité du canal du côté source en épousant le flanc de la couche diélectrique de grille permet d'éviter d'avoir un contact entre la région d'extension de source et la couche diélectrique de grille. Cette dernière étant le plus souvent réalisée dans un matériau à forte constante diélectrique (high-k), le contact de la région d'extension de source avec un matériau high-k entraîne une déplétion importante de la région d'extension de source évitée grâce à la présente invention. En ce sens, le transistor selon l'invention présente deux différences majeures avec le document « Impact of SOI, Si₁₋ₓGeₓOI and GeOI substrates on CMOS compatible Tunnel FET performance » (F. Mayer et al. - Tech. Dig.-Int. Electron Devices Meet. - 2008) identifié plus haut : le dispositif décrit dans ce document comporte en effet un premier espaceur dont l'épaisseur est de l'ordre de 10nm, donc beaucoup plus élevée que l'épaisseur du premier espaceur selon l'invention ; en outre, ce premier espaceur ne recouvre pas la partie latérale de la couche diélectrique de grille. Ce sont précisément ces deux caractéristiques qui permettent d'obtenir l'effet technique recherché entraînant une forte augmentation du courant de conduction. S'agissant du document« Tunnel field effect transistor with increased ON current, low-k spacer and hick-k dielectric » (Anghel et al., Applied Physics Letters 96, 122104 (2010)), ce dernier décrit un seul espaceur de forte épaisseur (environ 20nm) avec une épaisseur de zone d'extension de source identique à celle du canal.

Le transistor selon l'invention peut également présenter une ou plusieurs des caractéristiques ci-dessous, considérées individuellement ou selon toutes les combinaisons techniquement possibles :
- selon un mode de réalisation particulièrement avantageux, ledit premier espaceur est réalisé dans un matériau diélectrique low-k et ladite couche diélectrique de grille est réalisée dans un matériau high-k ; on entend par matériau high-k ou matériau diélectrique à forte constante diélectrique un matériau ayant une constante diélectrique k strictement supérieure à 3.9 (constante diélectrique de l'oxyde de silicium) ;
- préférentiellement, ledit deuxième espaceur est réalisé dans un matériau diélectrique low-k ; on entend par matériau low-k ou matériau diélectrique à faible constante diélectrique un matériau ayant une constante diélectrique k inférieure ou égale à 3.9 ;
- la longueur dudit premier espaceur est comprise entre 1 et 4 nm ;
- de manière particulièrement avantageuse, la longueur dudit premier espaceur est comprise entre 1 et 2 nm ;
- selon un mode de réalisation préférentiel, ladite surépaisseur de ladite région d'extension de source est sensiblement égale à l'épaisseur de la couche diélectrique de grille ;
- ledit canal et ladite région d'extension de drain présentent la même épaisseur ;
- ladite région conductrice de drain recouvre intégralement la région d'extension de drain ;
- lesdits moyens pour former un espace isolant de drain entre les flancs respectifs de ladite structure de grille et de ladite région conductrice de drain en regard l'un de l'autre sont au contact dudit canal et s'étendent au-dessus de l'extrémité dudit canal du côté de la région d'extension de drain ;
- la deuxième face dudit deuxième espaceur est au contact du flanc de la région conductrice de source ;
- ledit transistor est un transistor à double grille présentant une structure symétrique au-dessus et au-dessous dudit canal prolongé de part et d'autre par les régions d'extension de source et de drain, ledit transistor comportant :
   ○ des secondes régions conductrices de source et de drain respectivement en contact avec les régions d'extension de source et de drain et s'étendant respectivement au-dessous des régions d'extension de source et de drain ;
   ○ une seconde structure de grille au-dessous dudit canal et agencée de sorte qu'une extrémité dudit canal n'est pas recouverte par la seconde structure de grille du côté de la région d'extension de source, ladite seconde structure de grille comportant :
      ■ une couche diélectrique de grille en contact avec ledit canal ;
      ■ une zone de grille au-dessous de ladite couche diélectrique de grille de sorte que ladite couche diélectrique de grille est disposée entre ladite zone de grille et ledit canal ;
   ○ des moyens pour former un espace isolant de drain entre les flancs respectifs de ladite seconde structure de grille et de ladite seconde région conductrice de drain en regard l'un de l'autre ;
   ○ des moyens pour former un espace isolant de source entre les flancs respectifs de ladite seconde structure de grille et ladite seconde région conductrice de source en regard l'un de l'autre, lesdits moyens comportant un premier et un deuxième espaceur diélectriques inférieurs présentant chacun une première et une deuxième face latérale ; ladite région d'extension de source présentant une seconde surépaisseur en regard de ladite couche diélectrique de grille de ladite seconde structure de grille,
      la première face dudit premier espaceur inférieur étant au contact du flanc de ladite zone de grille suivi du flanc de ladite couche diélectrique de grille de ladite seconde structure de grille de sorte que ladite première face recouvre l'intégralité du flanc de ladite couche diélectrique,
      la deuxième face dudit premier espaceur inférieur étant au contact de la première face dudit deuxième espaceur inférieur et se prolonge le long du flanc de ladite seconde surépaisseur de la région d'extension de source,
      le premier espaceur inférieur recouvrant la surface inférieure de l'extrémité dudit canal non recouverte par la seconde structure de grille et présentant une longueur strictement inférieure à 5nm, ladite longueur étant mesurée selon la direction longitudinale dudit canal.

D'autres caractéristiques et avantages de l'invention ressortiront clairement de la description qui en est donnée ci-dessous, à titre indicatif et nullement limitatif, en référence aux figures annexées, parmi lesquelles :
- la figure 1 illustre un exemple de structure d'un transistor TFET selon l'état de la technique ;
- la figure 2 représente le diagramme de bande du transistor de la figure 1 ;
- la figure 3 illustre un second exemple de structure de transistor TFET selon l'état de la technique ;
- la figure 4 représente la structure d'un transistor à effet tunnel à simple grille selon l'invention ;
- la figure 5 représente la structure d'un transistor à effet tunnel à double grille selon l'invention ;
- la figure 6 représente un agrandissement de la zone active du transistor de la figure 5 ;
- La figure 7 représente l'évolution du courant Iₒₙ en fonction de la tension de grille VG positive pour les transistors de la figure 1 et de la figure 5 ;
- La figure 8 représente les mêmes caractéristiques courant-tension que celles de la figure 7 en échelle semi-logarithmique ;
- les figures 9a à 9c illustrent les densités de courant de conduction pour des transistors TFET présentant différentes épaisseurs de région d'extension de source ;
- la figure 10 représente l'évolution de la densité de courant de conduction en fonction de la tension de grille pour des transistors TFET présentant différentes épaisseurs de région d'extension de source ;
- les figures 11a à 11c illustrent les zones de déplétion pour des transistors TFET présentant différentes épaisseurs de région d'extension de source ;
- la figure 12 représente l'évolution de la densité de courant de conduction en fonction de la tension de grille pour des transistors TFET présentant différentes longueurs d'espaceur ;
- les figures 13a à 13h illustrent les étapes d'un premier mode de réalisation d'un procédé de fabrication d'un dispositif selon l'invention ;
- les figures 14a à 14f illustrent les étapes d'un second mode de réalisation d'un procédé de fabrication d'un dispositif selon l'invention ;
- les figures 15a à 15d illustrent les étapes d'un troisième mode de réalisation d'un procédé de fabrication d'un dispositif selon l'invention.

Dans toutes les figures, les éléments communs portent les mêmes numéros de référence. Pour des raisons de clarté, seuls les éléments utiles pour la compréhension de l'invention ont été représentés, et ceci sans respect de l'échelle et de manière schématique.

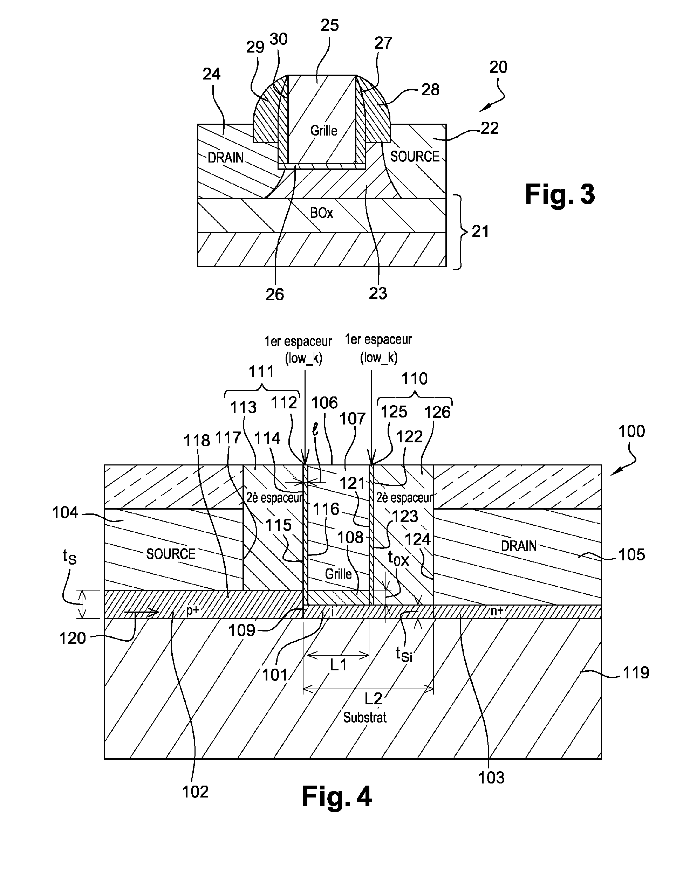

La figure 4 représente schématiquement la structure d'un transistor à effet tunnel TFET 100 à simple grille selon l'invention.

Le transistor à effet tunnel 100 est ici un transistor de type N comportant une architecture de diode PiN formée sur un substrat 119 (par exemple un substrat de type silicium sur isolant) incluant :
- un canal central 101 réalisé dans un matériau semiconducteur (par exemple du silicium) intrinsèque ; on entend par semiconducteur intrinsèque un matériau semiconducteur dont le comportement électrique ne dépend que de sa structure, et non de l'adjonction d'impuretés dopantes ;
- une région d'extension de source 102 prolongeant le canal 101 à l'une de ses extrémités et réalisée dans un matériau semiconducteur fortement dopé P de type P+ (par exemple du Si dopé B) ;
- une région d'extension de drain 103 prolongeant le canal 101 à l'autre de ses extrémités et réalisée dans un matériau semiconducteur fortement dopé N de type N+ (par exemple du Si dopé P).

Comme nous le détaillerons par la suite, l'épaisseur t_{S} de la région d'extension de source 102 est supérieure à l'épaisseur t_{Si} du canal 101 ; on entend par épaisseur la dimension mesurée suivant la direction perpendiculaire au substrat.

Le transistor 100 comporte :
- une structure de grille 106 comportant :
   ○ une couche diélectrique 108 de grille ; le matériau de la couche diélectrique 108 est préférentiellement un matériau diélectrique de type high-k tel que le HfO₂ ;
   ○ une zone conductrice de grille 107 au-dessus de la couche diélectrique de grille 108 et au-contact de celle-ci ; le matériau de la zone conductrice de grille 108 est par exemple un métal ;
- une région conductrice de source 104 ;
- une région conductrice de drain 105 ;
- des moyens 110 pour former un espace isolant de drain entre les flancs en regard l'un de l'autre de la structure de grille 106 et de la région conductrice de drain 105 ;
- des moyens 111 pour former un espace isolant de source entre les flancs en regard l'un de l'autre de la structure de grille 106 et de la région conductrice de source 104.

Les moyens 110 pour former un espace isolant de drain comportent :
- un premier espaceur 125 présentant une première face latérale 121 et une deuxième face latérale 122 ;
- un deuxième espaceur 126 présentant une première face latérale 123 et une deuxième face latérale 124.

De même, les moyens 111 pour former un espace isolant de source comportent :
- un premier espaceur 112 présentant une première face latérale 116 et une deuxième face latérale 115 ;
- un deuxième espaceur 113 présentant une première face latérale 114 et une deuxième face latérale 117.

L'ensemble des espaceurs est préférentiellement réalisé dans un matériau diélectrique low-k tel que du SiO₂.

Le transistor 100 se présente sous la forme d'une série d'éléments successifs situés au-dessus de l'ensemble formé par le canal 101 entouré des régions d'extension 102 et 103, dans le sens longitudinal du canal à partir de la région d'extension de source (repéré par la flèche 120) :
- la région conductrice de source 104 ;
- le deuxième espaceur 113 des moyens 111 formant un espace isolant de source ;
- le premier espaceur 112 des moyens 111 formant un espace isolant de source ;
- la structure de grille 106 ;
- le premier espaceur 125 des moyens 110 formant un espace isolant de drain ;
- le deuxième espaceur 126 des moyens 110 formant un espace isolant de drain ;
- la région conductrice de drain 105.

Nous allons dans ce qui suit détailler l'agencement de cette série d'éléments successifs.

La région conductrice de source 104 surmonte la région d'extension de source 102 et est au contact de celle-ci sur la première partie de sa longueur. Cette région conductrice de source 104 est par exemple une région métallique obtenue par siliciuration.

Le deuxième espaceur 113 des moyens 111 formant un espace isolant de source surmonte la région d'extension de source 102 et est au contact de celle-ci sur la partie de sa longueur non recouverte par la région conductrice de source (i.e. jusqu'à l'interface avec le canal 101). La deuxième face latérale 117 du deuxième espaceur 113 des moyens 111 formant un espace isolant de source est au contact du flanc de la région conductrice de source 104 en regard de ladite deuxième face. Le rôle du deuxième espaceur 113 est d'assurer l'isolation électrostatique entre la région conductrice de source 104 et la zone de grille 106.

Le premier espaceur 112 des moyens 111 formant un espace isolant de source présente une longueur I (calculée selon le sens longitudinal du canal repéré par la flèche 120) strictement inférieure à 5nm, de manière particulièrement avantageuse comprise entre 1 et 2 nm. Le premier espaceur 112 surmonte l'extrémité 109 du canal 101 et est au contact de cette extrémité sur ladite longueur I. La deuxième face latérale 115 du premier espaceur 112 est en contact direct de la première face latérale 114 du deuxième espaceur 113.

La structure de grille 106 surmonte le canal 101 sur une longueur L1 et est agencée de sorte que le canal 101 présente une extrémité libre de longueur I (recouverte par le premier espaceur 112 tel que mentionné ci-dessus).

On notera que la couche diélectrique 108 et la zone de grille 107 présentent des flancs latéraux sensiblement alignés (i.e. ont une longueur L1 identique suivant la direction 120). La première face latérale 116 du premier espaceur 112 des moyens 111 formant un espace isolant de source est en contact direct avec les flancs de la couche diélectrique 108 et de la zone de grille 107 en regard. Il convient de noter que la première face latérale 116 du premier espaceur 112 recouvre le flanc de la couche diélectrique 108 sur toute son épaisseur tOx. Comme évoqué plus haut, l'épaisseur tS de la région d'extension de source 102 est supérieure à l'épaisseur tSi du canal 101 ; de manière particulièrement avantageuse, la région d'extension de source 102 présente une surépaisseur 118 égale à l'épaisseur tOx de la couche diélectrique 108 de sorte que les surfaces supérieures de la région d'extension de source 102 et de la couche diélectrique de grille 108 soient alignées. En d'autres termes, l'épaisseur totale tS de la région d'extension de source 102 est égale à la somme de l'épaisseur tSi du canal 101 et de l'épaisseur tOx de la couche diélectrique de grille 108. Ainsi, le premier espaceur 112 est utilisé pour séparer la couche diélectrique de grille 108 de la surépaisseur 118 de la région d'extension de source 102. Comme nous le verrons par la suite, la surépaisseur 118 permet d'éviter la déplétion de la région d'extension de source 102 causée par la zone de grille 106.

La couche diélectrique de grille 108 est disposée entre la zone de grille 107 et le canal 101 et est réalisée préférentiellement dans un matériau de type high-k tel que du HfO₂. Dans le prolongement du premier espaceur 112, la couche diélectrique surmonte le canal 101 et est au contact de ce dernier sur toute sa longueur L1 (correspondant à une partie de la longueur totale L2 du canal).

La première face latérale 121 du premier espaceur 125 des moyens 110 formant un espace isolant de drain est en contact direct avec les flancs de la couche diélectrique 108 et de la zone de grille 107 en regard. Comme précédemment dans le cas des espaceurs de source, la première face latérale 121 du premier espaceur 125 recouvre le flanc de la couche diélectrique 108 sur toute son épaisseur tOx.

La deuxième face latérale 122 du premier espaceur 125 des moyens 110 formant un espace isolant de drain est en contact direct de la première face latérale 123 du deuxième espaceur 126 des moyens 110 formant un espace isolant de drain.

Les premier et deuxième espaceurs 125 et 126 des moyens 110 formant un espace isolant de drain surmontent le canal 101 et sont au contact de ce dernier sur toute la longueur restante correspondant à L2-L1 non recouverte par la couche diélectrique de grille 108 et le premier espaceur 112.

On passe ensuite à la région située au-dessus de la région d'extension de drain 103.

La région conductrice de drain 105 surmonte la région d'extension de drain 103 et est au contact de celle-ci sur toute sa longueur. Cette région conductrice de drain 105 est par exemple une région métallique obtenue par siliciuration.

La deuxième face latérale 124 du deuxième espaceur 126 des moyens 110 formant un espace isolant de drain est au contact du flanc de la région conductrice de drain 105 en regard de ladite deuxième face 124.

On remarque qu'une asymétrie a été introduite entre la source et le drain pour réduire le caractère ambipolaire du transistor 100. Ainsi, la zone de grille 106 recouvre seulement une partie du canal 101 à partir de la région d'extension de source 102 alors que le reste du canal 101 du côté de la région d'extension de drain 103 n'est pas recouverte par la zone de grille 106.

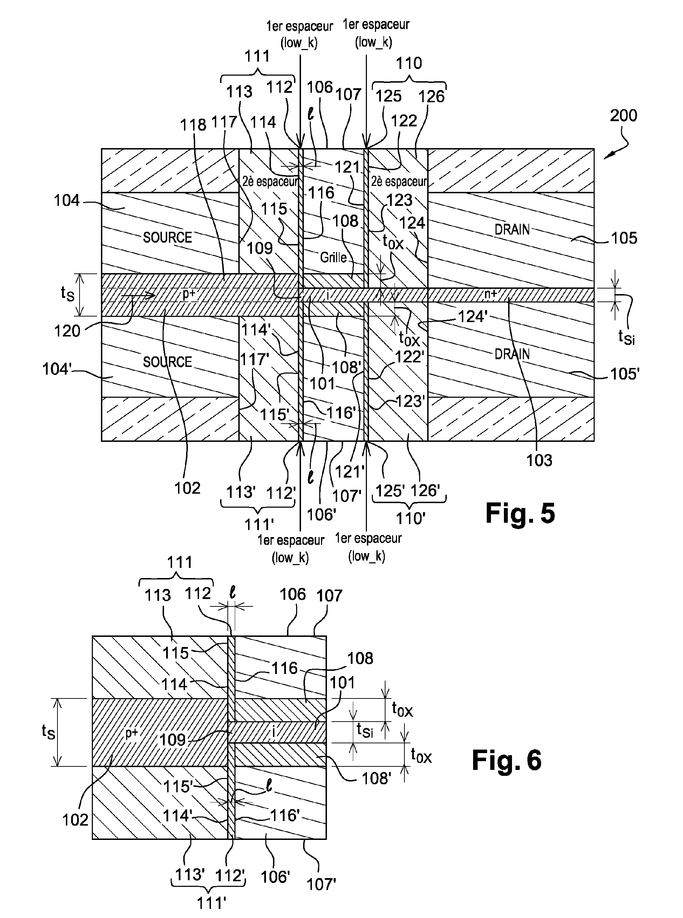

La figure 5 représente schématiquement la structure d'un transistor à effet tunnel TFET 200 à double grille selon l'invention.

Le transistor TFET 200 comporte les mêmes éléments que ceux du transistor à effet tunnel 100 à simple grille de la figure 4 (les références communes sont identiques sur les deux figures 4 et 5). Le transistor 200 intègre en plus une partie inférieure intégrant notamment la grille de commande inférieure. Cette partie inférieure est totalement symétrique de la partie supérieure du transistor par rapport au plan du substrat. Dans ce qui suit, l'association de la notation « ' » (prime) à une référence numérique d'un élément de la figure 5 indique qu'il s'agit d'un élément inférieur (i.e. au-dessous du canal 101). Outre les caractéristiques du transistor 100 de la figure 4, le transistor 200 comporte sur sa partie inférieure une structure de grille inférieure 106' comportant :
- une couche diélectrique 108' de grille ; le matériau de la couche diélectrique 108' est préférentiellement un matériau diélectrique de type high-k tel que le HfO₂ ;
- une zone conductrice de grille 107' au-dessous de la couche diélectrique de grille 108' et au-contact de celle-ci ; le matériau de la zone conductrice de grille 108' est par exemple un métal ;
- des moyens 110' pour former un espace isolant de drain entre les flancs en regard l'un de l'autre de la structure de grille 106' et de la région conductrice de drain 105' ;
- des moyens 111' pour former un espace isolant de source entre les flancs en regard l'un de l'autre de la structure de grille 106' et la région conductrice de source 104'.

Les moyens 110' pour former un espace isolant de drain comportent :
- un premier espaceur 125' présentant une première face latérale 121' et une deuxième face latérale 122' ;
- un deuxième espaceur 126' présentant une première face latérale 123' et une deuxième face latérale 124'.

De même, les moyens 111' pour former un espace isolant de source comportent :
- un premier espaceur 112' présentant une première face latérale 116' et une deuxième face latérale 115' ;
- un deuxième espaceur 113' présentant une première face latérale 114' et une deuxième face latérale 117'.

Le transistor 200 se présente sous la forme d'une série d'éléments successifs situés au-dessous de l'ensemble formé par le canal 101 entouré des régions d'extension 102 et 103, dans le sens longitudinal du canal à partir de la région d'extension de source (repéré par la flèche 120) :
- la région conductrice de source 104' ;
- le deuxième espaceur 113' des moyens 111' formant un espace isolant de source ;
- le premier espaceur 112' des moyens 111' formant un espace isolant de source ;
- la structure de grille inférieure 106' ;
- le premier espaceur 125' des moyens 110' formant un espace isolant de drain ;
- le deuxième espaceur 126' des moyens 110' formant un espace isolant de drain ;
- la région conductrice de drain 105'.

Nous allons dans ce qui suite détailler l'agencement de cette série d'éléments successifs.

La région conductrice de source 104' est au-dessous de la région d'extension de source 102 et est au contact de celle-ci sur la première partie de sa longueur. Cette région conductrice de source 104' est par exemple une région métallique obtenue par siliciuration.

Le deuxième espaceur 113' des moyens 111' formant un espace isolant de source est au-dessous de la région d'extension de source 102 et est au contact de celle-ci sur la partie de sa longueur non recouverte par la région conductrice de source 104' (i.e. jusqu'à l'interface avec le canal 101). La deuxième face latérale 117' du deuxième espaceur 113' des moyens 111' formant un espace isolant de source est au contact du flanc de la région conductrice de source 104' en regard de ladite deuxième face.

Comme le premier espaceur supérieur 112, le premier espaceur 112' des moyens 111' formant un espace isolant de source présente une longueur I (calculée selon le sens longitudinal du canal repéré par la flèche 120) strictement inférieure à 5nm, de manière particulièrement avantageuse comprise entre 1 et 2 nm. Le premier espaceur 112' est au-dessous de l'extrémité 109 du canal 101 et est au contact de cette extrémité sur ladite longueur I. La deuxième face latérale 115' du premier espaceur 112' est en contact direct de la première face latérale 114' du deuxième espaceur 113'.

La structure de grille inférieure 106' est au-dessous du canal 101 sur la longueur L1. La structure de grille 106' comporte une couche diélectrique de grille 108' en contact avec le canal 101 et une zone de grille 107' au-dessous de ladite couche diélectrique de grille.

La couche diélectrique 108' et la zone de grille 107' présentent des flancs latéraux sensiblement alignés (i.e. ont une longueur L1 identique suivant la direction 120). La première face latérale 116' du premier espaceur 112' des moyens 111' formant un espace isolant de source est en contact direct avec les flancs de la couche diélectrique 108' et de la zone de grille 107' en regard. La première face latérale 116' du premier espaceur 112' recouvre le flanc de la couche diélectrique 108' sur toute son épaisseur tOx. Comme évoqué plus haut, l'épaisseur tS de la région d'extension de source 102 est supérieure à l'épaisseur tSi du canal 101 ; de manière particulièrement avantageuse, la région d'extension de source 102 présente une seconde surépaisseur égale à l'épaisseur tOx de la couche diélectrique 108' de sorte que les surfaces inférieures de la région d'extension de source 102 et de la couche diélectrique de grille 108' soient alignées. En d'autres termes, l'épaisseur totale tS de la région d'extension de source 102 est égale à la somme de l'épaisseur tSi du canal 101, de l'épaisseur tOx de la couche diélectrique supérieure de grille 108 et de l'épaisseur tOx de la couche diélectrique inférieure de grille 108' (i.e. tS=tSi +2.tOx). La figure 6 représente un agrandissement de la zone active du transistor 200 montrant l'augmentation de l'épaisseur tS de la zone d'extension de source 102 par rapport à l'épaisseur tSi du canal 101.

La couche diélectrique de grille 108' est disposée entre la zone de grille 107' et le canal 101 et est réalisée préférentiellement dans un matériau de type high-k tel que du HfO₂. Dans le prolongement du premier espaceur 112', la couche diélectrique 108' est au-dessous du canal 101 et est au contact de ce dernier sur toute sa longueur L1 (correspondant à une partie de la longueur L2 du canal).

La première face latérale 121' du premier espaceur 125' des moyens 110' formant un espace isolant de drain est en contact direct avec les flancs de la couche diélectrique 108' et de la zone de grille 107' qui sont en regard. Comme précédemment dans le cas des espaceurs de source, la première face latérale 121' du premier espaceur 125' recouvre le flanc de la couche diélectrique 108' sur toute son épaisseur tOx.

La deuxième face latérale 122' du premier espaceur 125' des moyens 110' formant un espace isolant de drain est en contact direct de la première face latérale 123' du deuxième espaceur 126' des moyens 110' formant un espace isolant de drain.

Les premier et deuxième espaceurs 125' et 126' des moyens 110' formant un espace isolant de drain sont au-dessous du canal 101 et sont au contact de ce dernier sur toute la longueur restante correspondant à L2-L1 non recouverte par la couche diélectrique de grille 108' et le premier espaceur 112'.

On passe ensuite à la région située au-dessous de la région d'extension de drain 103.

La région conductrice de drain 105' est au-dessous de la région d'extension de drain 103 et est au contact de celle-ci sur toute sa longueur. Cette région conductrice de drain 105' est par exemple une région métallique obtenue par siliciuration.

La deuxième face latérale 124' du deuxième espaceur 126' des moyens 110' formant un espace isolant de drain est au contact du flanc de la région conductrice de drain 105' en regard de ladite deuxième face 124'.

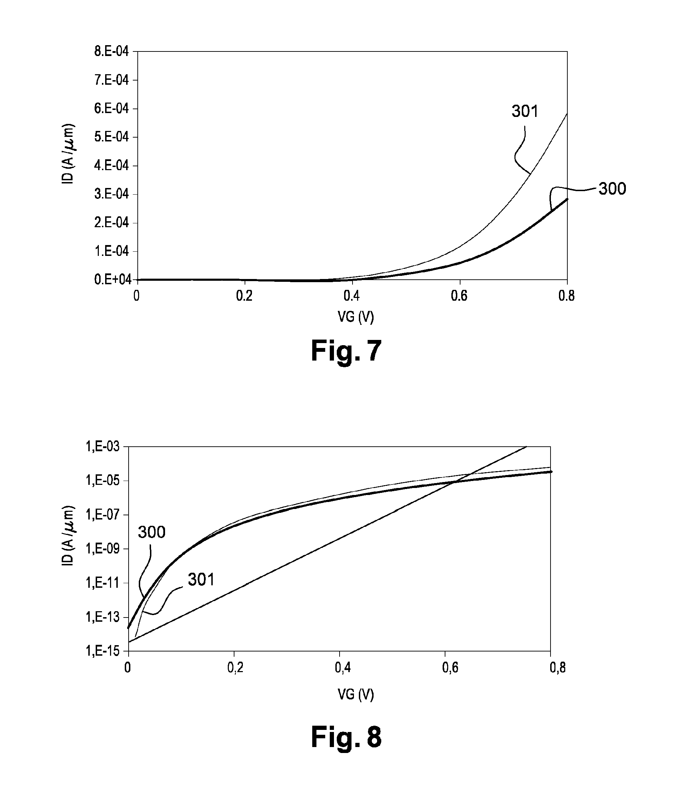

La figure 7 représente l'évolution de la densité ID du courant Iₒₙ en fonction de la tension de grille VG positive en maintenant une tension positive constante au niveau du drain de façon à polariser la diode PiN en inverse. Deux caractéristiques courant-tension sont représentées : la première caractéristique 300 correspondant à la caractéristique du transistor 1 de la figure 1 et la seconde caractéristique 301 correspond à la caractéristique du transistor 200 de la figure 5. Les résultats présentés sur ses deux courbes montrent clairement que le courant Iₒₙ est bien supérieur dans le cas du transistor 200 selon l'invention que dans le cas du transistor 1 selon l'état de la technique.

La figure 8 représente les mêmes caractéristiques courant-tension que celles de la figure 7 mais en échelle semi-logarithmique. On observe que la pente sous le seuil du transistor selon l'invention est supérieure à la pente sous le seuil du transistor selon l'état de la technique. Cet effet est particulièrement intéressant dans la mesure où plus la pente sous le seuil est élevée, plus le courant sous seuil sera négligeable pour une tension de grille donnée.

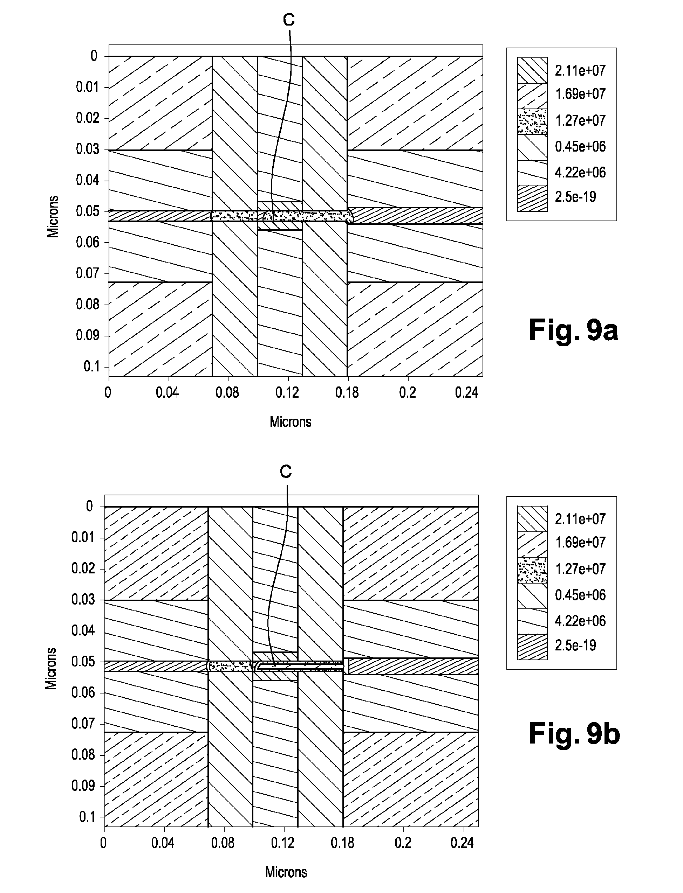

Les figures 9a à 9c illustrent les densités de courant pour différents transistors TFET ayant chacun une épaisseur de canal tSi égale à 3nm et une épaisseur tOx de couche diélectrique inférieure et supérieure de grille égale à 3nm.

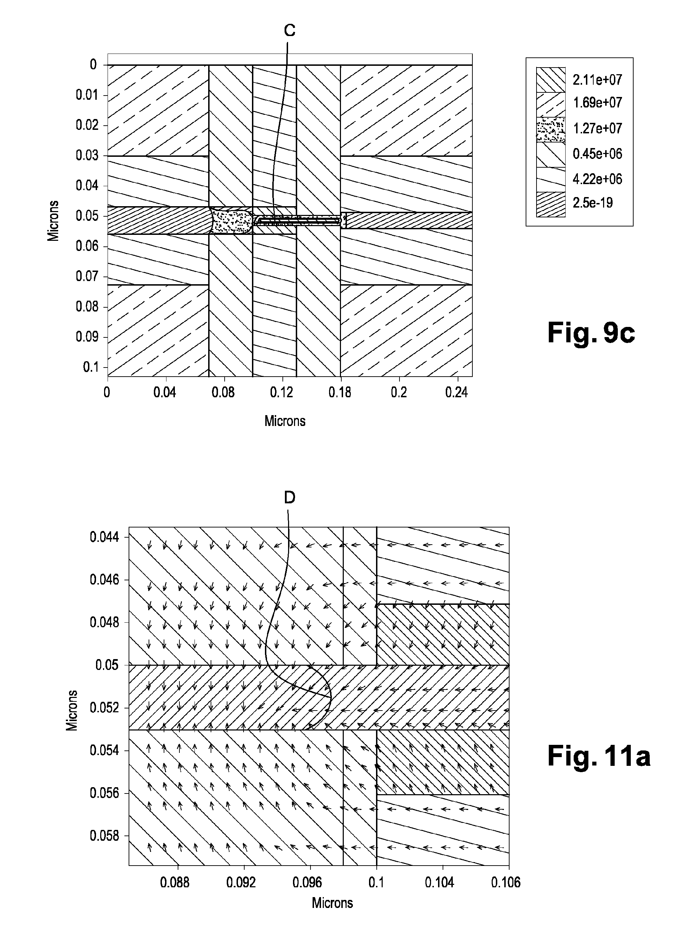

Les transistors utilisés sont respectivement :
- un transistor tel que le transistor 1 de la figure 1 pour lequel l'épaisseur tS de la région d'extension de source est égale à 3nm, c'est-à-dire à l'épaisseur tSi du canal (figure 9a) ;
- un transistor selon l'invention pour lequel l'épaisseur totale tS de la région d'extension de source est égale à égale à 5nm ; en d'autres termes, l'épaisseur tS est strictement supérieure à l'épaisseur du canal tSi et inférieure à la somme de l'épaisseur tSi du canal, de l'épaisseur tOx de la couche diélectrique supérieure de grille et de l'épaisseur tOx de la couche diélectrique inférieure de grille (i.e. tS=tSi +2.tOx) (figure 9b) ;
- un transistor selon l'invention tel que représenté en figure 5 pour lequel l'épaisseur totale tS de la région d'extension de source est égale à - 9nm ; en d'autres termes, l'épaisseur tS est égale à la somme de l'épaisseur tSi du canal, de l'épaisseur tOx de la couche diélectrique supérieure de grille et de l'épaisseur tOx de la couche diélectrique inférieure de grille (i.e. tS=tSi +2.tOx) (figure 9c) ;

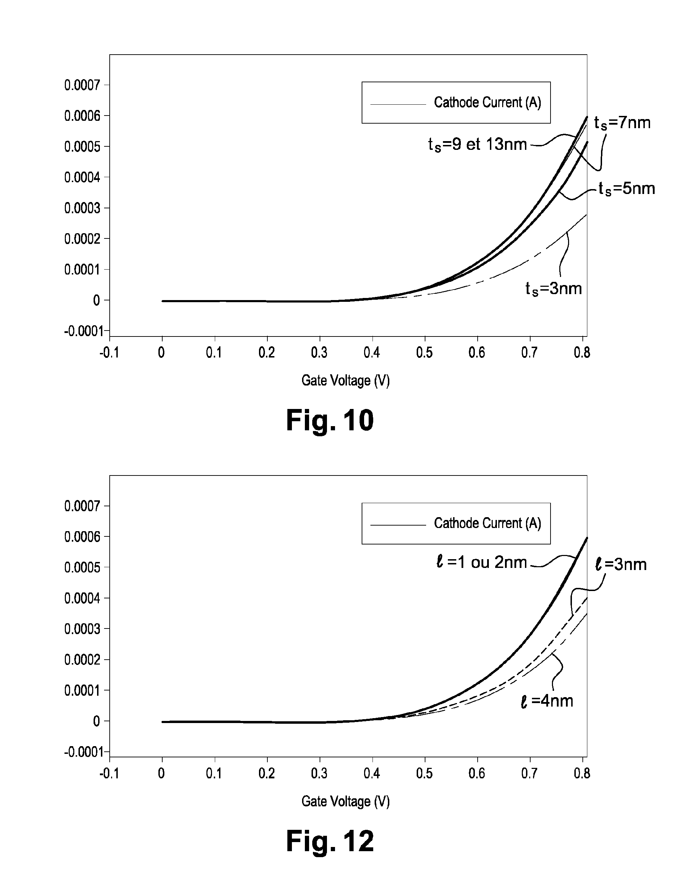

On constate que la densité de courant dans le canal (référencé par la lettre C sur les figures 9a à 9c augmente lorsque l'épaisseur tS augmente. Une augmentation de l'épaisseur tS au-delà de tSi + 2.tOx (ou au-delà de tSi + tOx dans le cas d'un transistor à simple grille) ne permet pas d'augmenter davantage la densité de courant dans le canal. En revanche, une telle épaisseur pourrait entraîner un contact entre la région d'extension de source et le premier espaceur low-k (i.e. les premiers espaceurs 112 et 112') au-dessus de la couche diélectrique de grille : un tel contact n'est pas souhaitable car il pourrait alors induire des capacités parasites. L'absence d'effet d'une augmentation de l'épaisseur tS au-delà de tSi + 2.tOx est confirmée par la figure 10 qui représente l'évolution de la densité de courant de conduction en fonction de la tension de grille pour des transistors TFET présentant différentes épaisseurs de région d'extension de source. On constate sur cette figure que le courant de conduction change peu lorsque l'épaisseur devient supérieure ou égale à 9nm (les courbes pour tS=9 et 13nm sont quasiment confondues) ; la diminution est en revanche déjà sensible lorsqu'on passe de 9nm à 7nm et encore plus sensible quand on passe de 9nm à 5nm.

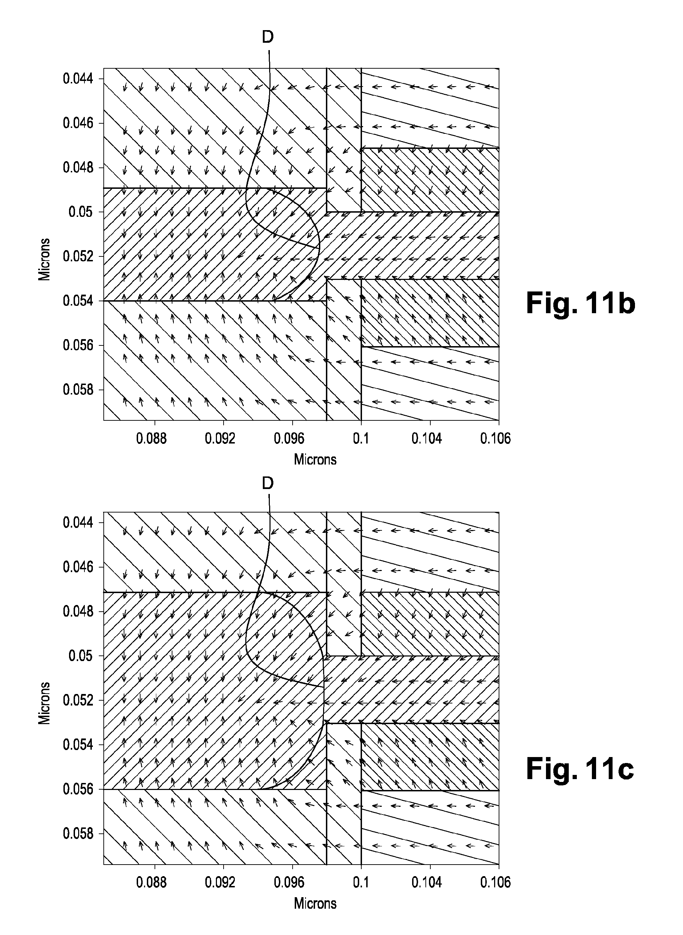

L'influence de l'épaisseur tS sur le transistor selon l'invention s'explique par l'influence de cette épaisseur sur la zone de déplétion à l'interface entre le canal et la zone d'extension de source. Les figures 11a à 11c illustrent les zones de déplétion D (la ligne pleine délimite la zone de déplétion) pour des transistors TFET présentant des épaisseurs de région d'extension de source égales à 3nm (figure 11a), 5nm (figure 11b) et 9nm (figure 11c). Plus l'épaisseur est importante plus la ligne pleine se rapproche de l'interface de sorte que la région de déplétion est réduite.

On peut toutefois envisager d'utiliser une épaisseur tS de région d'extension de source supérieure à tSi + 2.tOx dans le cas d'un transistor à double grille (ou supérieure à tSi + tOx dans le cas d'un transistor à simple grille) mais cela suppose de facetter les parties latérales de la région d'extension de source de manière à éviter les contacts avec le premier espaceur low-k. De tels procédés de facettage permettant d'élever la région d'extension de source au-dessus de la surface supérieure de la couche diélectrique de grille supérieure et/ou au-dessous de la surface inférieure de la couche diélectrique de grille inférieure sont par exemple décrits dans les documents (en particulier sur l'angle des facettes) « Impact of Epi Facets on Deep Submicron Elevated Source/Drain MOSFET Characteristics » (Jie J. Sun and Carlton M. Osburn, - IEEE TRANSACTIONS ON ELECTRON DEVICES, VOL. 45, NO. 6, JUNE 1998) ou « Ultra-shallow in-situ-doped raised source drain structure for sub-tenth micron CMOS » (Y.Nakahar, K. Takeuchi, T.Tatsumi, Y.Ochiai, S.Manako, S.Samukawa and A.Furukawa, VLSI symp 1996, pp. 174-475).

Comme nous l'avons évoqué plus haut, les premiers espaceurs supérieur et inférieur 112 et 112' des moyens 111 et 111' formant un espace isolant de source présentent chacun une longueur I strictement inférieure à 5nm et de manière particulièrement avantageuse comprise entre 1 et 2 nm. L'effet de cette longueur sur le transistor selon l'invention est illustré sur la figure 12 qui représente quatre caractéristiques courant-tension (courant de conduction Ion en fonction de la tension de grille) pour quatre transistors se-Ion l'invention présentant respectivement des longueurs d'espaceur de 1, 2, 3 et 4nm. Les caractéristiques des transistors selon l'invention possédant une longueur de premier espaceur de 1 ou 2nm sont très proches et présentent des courants de conduction plus élevés que les caractéristiques des transistors selon l'invention présentant des longueurs de premier espaceur égales à 3 ou 4nm.

On notera que l'une des conséquences de la structure du transistor selon l'invention est que le dopage de la région d'extension de source est en retrait par rapport à la grille d'une longueur correspondant à la longueur du premier espaceur (i.e. préférentiellement comprise entre 1 et 2nm). Technologiquement, le dopage de la région de source est réalisé après la réalisation du premier espaceur : dès lors, le dopage s'arrête avant le premier espaceur. Ainsi, il n'y a aucun contact de type p+/high-k et on évite la déplétion au niveau de la région d'extension de source.

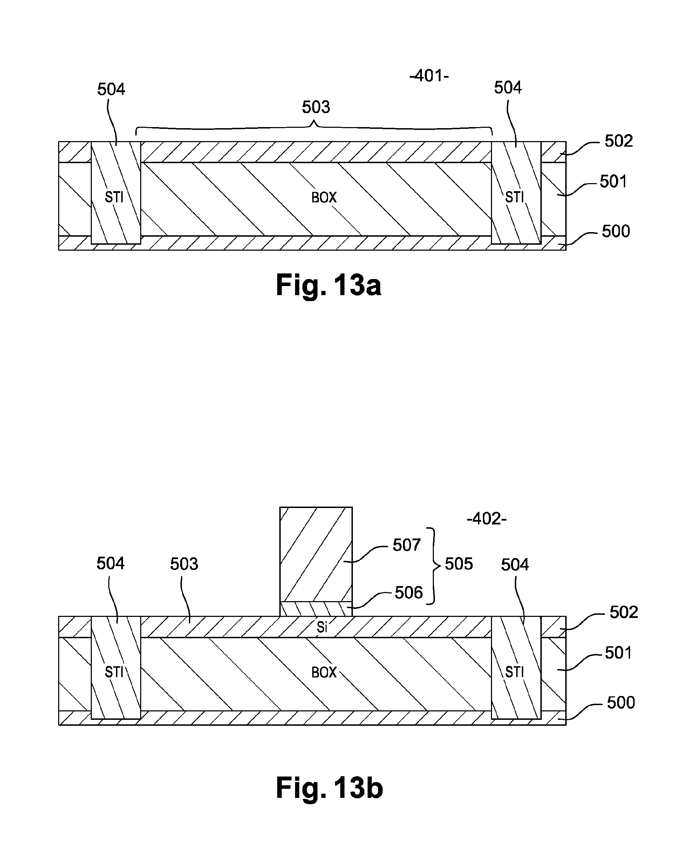

Les figures 13a à 13h illustrent les étapes d'un premier mode de réalisation d'un procédé de fabrication d'un dispositif selon l'invention. Selon cette première variante de réalisation, on utilisera une seule épitaxie pour la réalisation des zones de source et de drain. L'exemple est celui d'un transistor TFET de type N.

Selon la première étape 401 illustrée en figure 13a, on utilise un substrat du type semiconducteur sur isolant ou SOI (« Silicon On Insulator ») comprenant une première couche semiconductrice 500, par exemple à base de silicium sur laquelle repose une couche isolante 501 telle qu'une couche d'oxyde enterré (BOX ou « burried oxide » en anglais) à base de SiO₂ (le BOX peut être épais, par exemple sur une épaisseur de 145nm, ou préférentiellement mince pour le contrôle électrostatique, par exemple sur une épaisseur de 25nm). On a ensuite une fine couche semiconductrice 502 (par exemple un film mince de silicium par exemple sur une épaisseur inférieure à 30 nm voire inférieure à 10nm pour une technologie SOI de type « fully depleted »).

Selon cette même étape 401, on va définir la zone active 503, par exemple par la réalisation de tranchées 504. Ces tranchées sont réalisées par un procédé d'isolation par tranchées (STI pour « Shallow Trench Isolation). En STI, une gravure localisée des tranchées dans le substrat SOI est réalisée. Cette étape est suivie d'un remplissage des tranchées 504 de silice.

La zone active 503 peut également être réalisée par une gravure MESA.

La seconde étape 402 illustrée en figure 13b consiste à réaliser la structure de grille 505. Pour ce faire, on dépose par exemple une couche de diélectrique high-k 506 tel que du Hf02 puis une couche métallique et/ou de polysilicium dopé 507. La zone de grille 505 est ensuite obtenue par lithographie et gravure (avec arrêt sur la couche 502 de silicium) des couches diélectrique et métal/polySi déposées précédemment. On notera qu'on peut également déposer un masque dur (par exemple en SiN) au-dessus de la zone de grille 505 pour ne pas avoir de Silicium apparent en haut de la zone de grille (et éviter un impact sur la surface de grille au moment des épitaxies de source et de drain à venir).

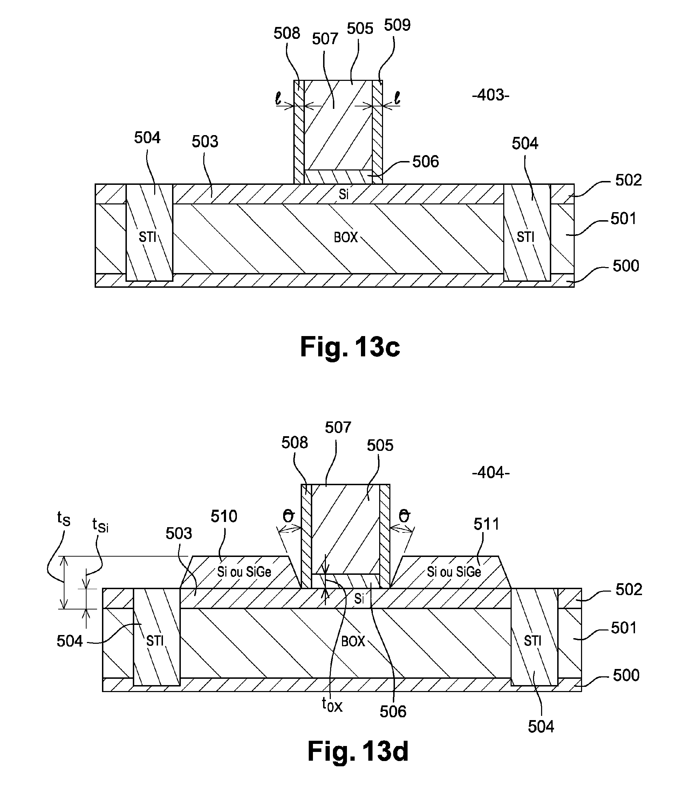

La troisième étape 403 illustrée en figure 13c consiste à réaliser les premiers espaceurs 508 et 509 (côté source et drain équivalents aux premiers espaceurs 112 et 125 de la figure 4). Cette réalisation est par exemple obtenue en faisant un dépôt conforme d'un matériau diélectrique de type low-k (tel que du SiO₂) sur une épaisseur typiquement inférieure à 10nm suivi d'une gravure anisotrope de type gravure sèche RIE (pour « Reactive Ion Etching »). Cette gravure anisotrope permet de définir la longueur I des espaceurs 508 et 509 (calculée selon le sens longitudinal du canal) strictement inférieure à 5nm, typiquement comprise entre 1 et 4 nm.

Selon l'étape 404 illustrée en figure 13d, on réalise par les régions d'extension de source 510 et de drain 511 par épitaxie sélective d'un matériau semiconducteur (par exemple du Si ou du SiGe non dopé, l'implantation pour la réalisation des dopages N et P restant à faire).

L'épitaxie sélective permet notamment d'obtenir une épaisseur t_{S} de la région d'extension de source 510 supérieure à l'épaisseur t_{Si} du canal (i.e. épaisseur de la zone active 503).

Contrairement au cas de la figure 4, la surépaisseur est ici supérieure (et non égale) à l'épaisseur t_{Ox} de la couche diélectrique 506. Afin d'éviter un contact entre la région d'extension de source et l'espaceur 508 au-dessus de la couche diélectrique 506, il est donc ici préférable de facetter la région d'extension de source en introduisant un angle θ entre les flancs respectifs de la région d'extension de source 510 et le premier espaceur 508.

L'angle θ est compris entre 1 ° et 45°.

On choisira l'épaisseur de la zone d'extension de source 510 typiquement comprise entre 5 et 20nm, le choix de ladite épaisseur étant fait de façon à minimiser les capacités et résistances parasites entre les zones de source/drain et la zone de grille.

Bien entendu, il est également possible de réaliser une zone d'extension de source parfaitement rectangulaire (cas des figures 4 et 5) sans facettes.

De par l'utilisation d'une seule épitaxie, il ressort ici que la zone d'extension de drain 511 est parfaitement symétrique de la zone d'extension de source 510. Par conséquent, les zones 510 et 511 ont ici la même épaisseur contrairement aux cas des figures 4 et 5 où seule la zone d'extension de source était surélevée.

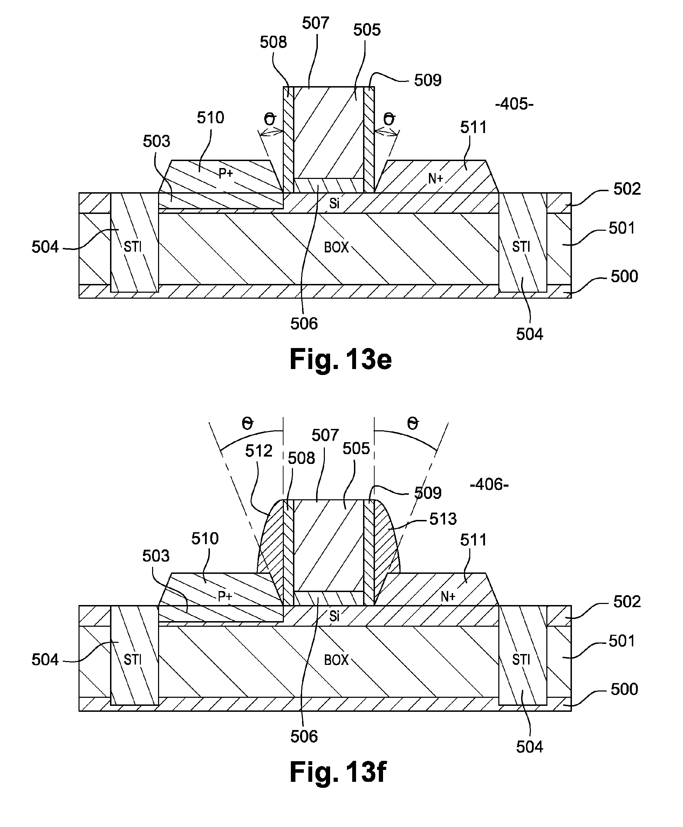

Selon l'étape 405 illustrée en figure 13e, on réalise le dopage P+ de la zone d'extension de source 510. Ce dopage est réalisé en définissant tout d'abord un caisson de résine (non représenté) dans lequel on ouvre la zone à doper (l'ouverture est obtenue par lithographie et gravure). La zone ouverte est dopée P+ par implantation ionique (par exemple une implantation par des ions B ou des ions BF2). Le caisson de résine est ensuite retiré par une méthode de type « stripping » ou « lift-off ».

Selon l'étape 406 illustrée en figure 13f, on définit les seconds espaceurs 512 et 513 respectivement en contact avec les premiers espaceurs 508 et 509. Cette définition peut être obtenue par dépôt conforme d'un matériau diélectrique tel que du SiO₂ ou du SiN (ou un empilement SiN/SiO₂) puis par gravure anisotrope. La durée de la gravure dépend de la longueur des seconds espaceurs typiquement comprise entre 5 et 15nm.

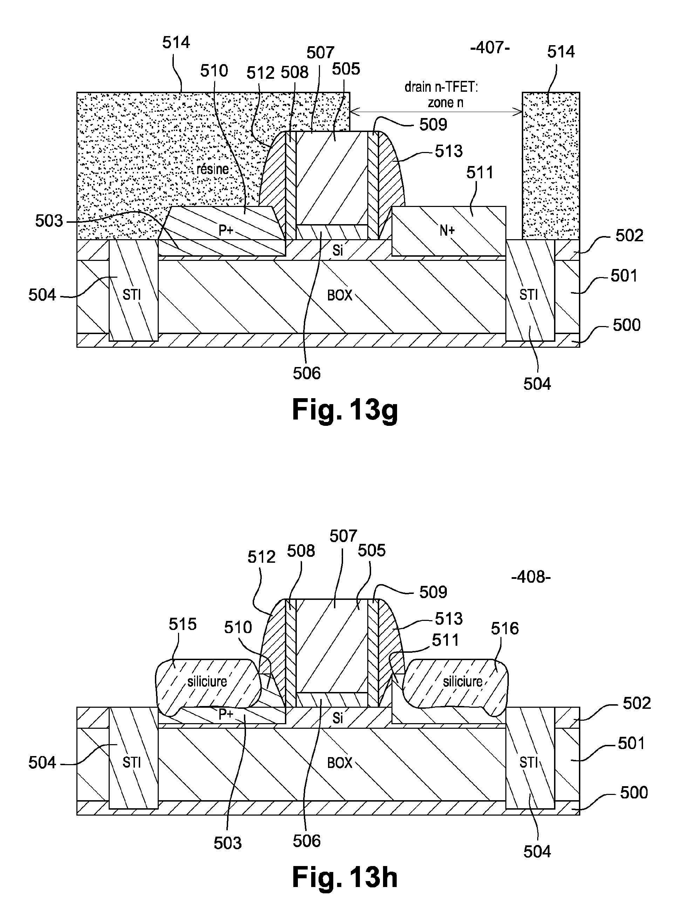

Selon l'étape 407 illustrée en figure 13g, on va réaliser le dopage N+ de la zone d'extension de drain 511. Ce dopage est réalisé en définissant tout d'abord un caisson de résine 514 dans lequel on ouvre la zone à doper

(l'ouverture est obtenue par lithographie et gravure). La zone ouverte est dopée N+ par implantation ionique (par exemple une implantation par des ions As ou P).

Selon l'étape 408 illustrée en figure 13h, on finalise le dispositif selon l'invention ; pour ce faire, le caisson de résine 514 est retiré par une méthode de type « stripping » ou « lift-off ». Afin d'activer les atomes dopants et de guérir les défauts dus au bombardement, on réalise ensuite un recuit d'implantation (dit également recuit d'activation). Afin de minimiser la résistance des zones d'extension de drain 511 et de source 510 réalisées en silicium monocristallin dopé, on effectue également une étape de siliciuration de ces zones 515 et 516 ; la siliciuration correspond à la métallisation de ces zones.

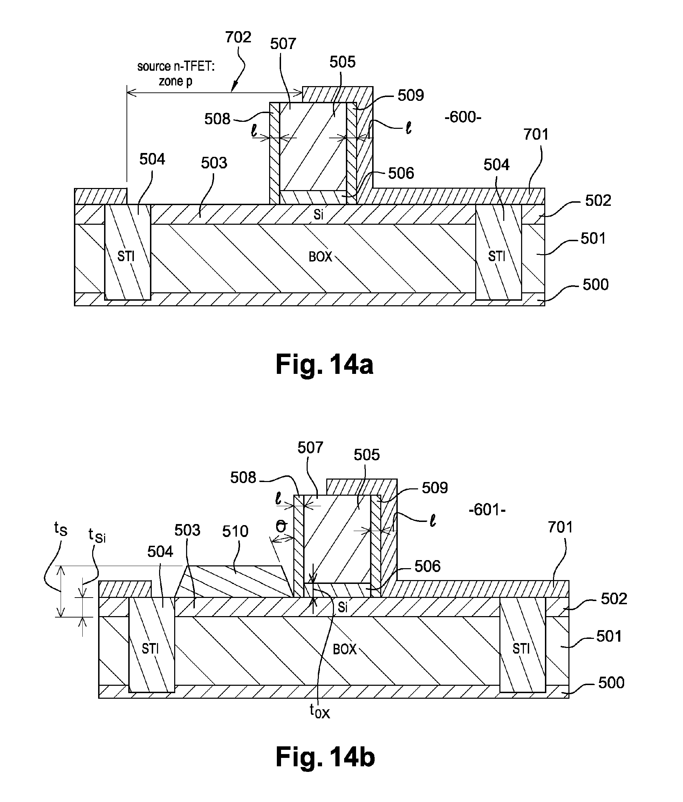

Les figures 14a à 14f illustrent les étapes d'un second mode de réalisation d'un procédé de fabrication d'un dispositif selon l'invention. Selon cette seconde variante de réalisation, on utilisera une seule épitaxie pour la réalisation de la zone de source (et pas d'épitaxie pour la zone de drain). L'exemple est à nouveau celui d'un transistor TFET de type N.

Les premières étapes non représentées de cette seconde variante sont identiques aux étapes illustrées aux figures 13a à 13c.

Selon l'étape 600 illustrée en figure 14a, on dépose un masque dur 701 recouvrant toute le dispositif à l'exception de la zone de source où l'on va épitaxier une zone d'extension de source surélevée. Pour ce faire, on dépose une couche de diélectrique (oxyde ou nitrure/oxyde) puis on réalise une lithographie et une gravure de la couche diélectrique pour ouvrir la couche 701 au niveau de la zone 702 où l'on veut réaliser l'épitaxie.

Selon l'étape 601 illustrée en figure 14b, on réalise la région d'extension de source 510 par épitaxie sélective d'un matériau semiconducteur (par exemple du Si ou du SiGe non dopé, l'implantation pour la réalisation du dopage P restant à faire).

L'épitaxie sélective permet notamment d'obtenir une épaisseur t_{S} de la région d'extension de source 510 supérieure à l'épaisseur t_{Si} du canal (i.e. épaisseur de la zone active 503).

Contrairement au cas de la figure 4, la surépaisseur est ici supérieure (et non égale) à l'épaisseur t_{Ox} de la couche diélectrique 506. Afin d'éviter un contact entre la région d'extension de source et l'espaceur 508 au-dessus de la couche diélectrique 506, il est donc ici préférable de facetter la région d'extension de source en introduisant un angle θ entre les flancs respectifs de la région d'extension de source 510 et le premier espaceur 508.

On choisira l'épaisseur de la zone d'extension de source 510 typiquement comprise entre 5 et 20nm.

Bien entendu, il est également possible de réaliser une zone d'extension de source parfaitement rectangulaire (cas des figures 4 et 5) sans facettes. Contrairement à la figure 13d, on utilise ici une épitaxie uniquement pour la réalisation d'une zone de source surélevée et non pour la réalisation simultanée des zones de source et de drain surélevées.

On notera qu'il est également possible de réaliser directement le dopage de la zone d'extension de source 510 en mettant en oeuvre une épitaxie dopée (ici par exemple une zone P+ avec du silicium ou du SiGe dopée in situ avec du bore).

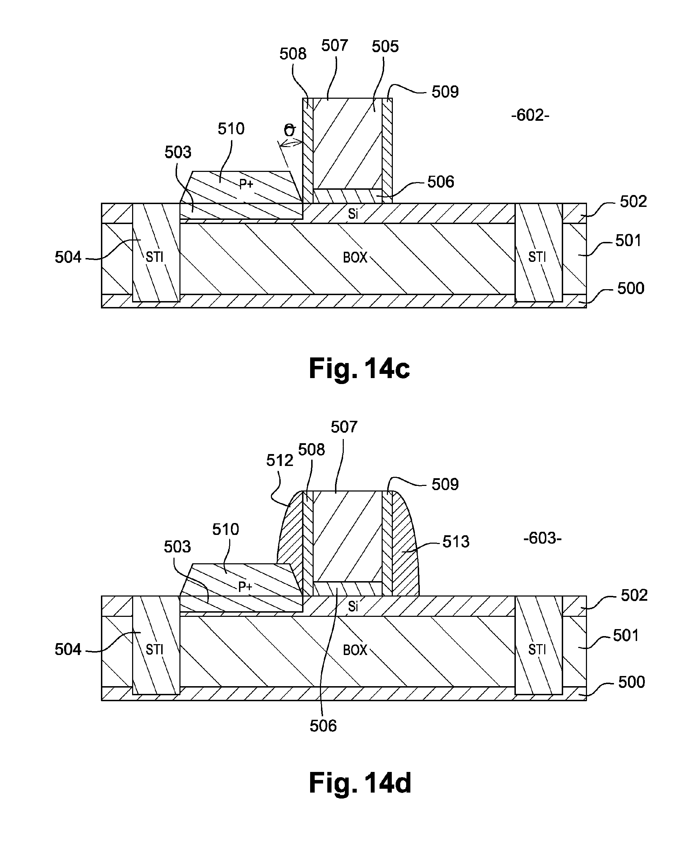

Selon l'étape 602 illustrée en figure 14c, on réalise le dopage P+ de la zone d'extension de source 510. Ce dopage est réalisé en définissant tout d'abord un caisson de résine (non représenté) dans lequel on ouvre la zone à doper (l'ouverture est obtenue par lithographie et gravure). La zone ouverte est dopée P+ par implantation ionique (par exemple une implantation par des ions B ou des ions BF2). Le caisson de résine ainsi que le masque dur 701 sont ensuite retirés par une méthode de type « stripping » ou « lift-off » .

Selon l'étape 603 illustrée en figure 14d, on définit les seconds espaceurs 512 et 513 respectivement en contact avec les premiers espaceurs 508 et 509. Cette définition peut être obtenue par dépôt conforme d'un matériau diélectrique tel que du SiO₂ ou du SiN (ou un empilement SiN/SiO₂) puis par gravure anisotrope. La durée de la gravure dépend de la longueur des seconds espaceurs typiquement comprise entre 5 et 15nm.

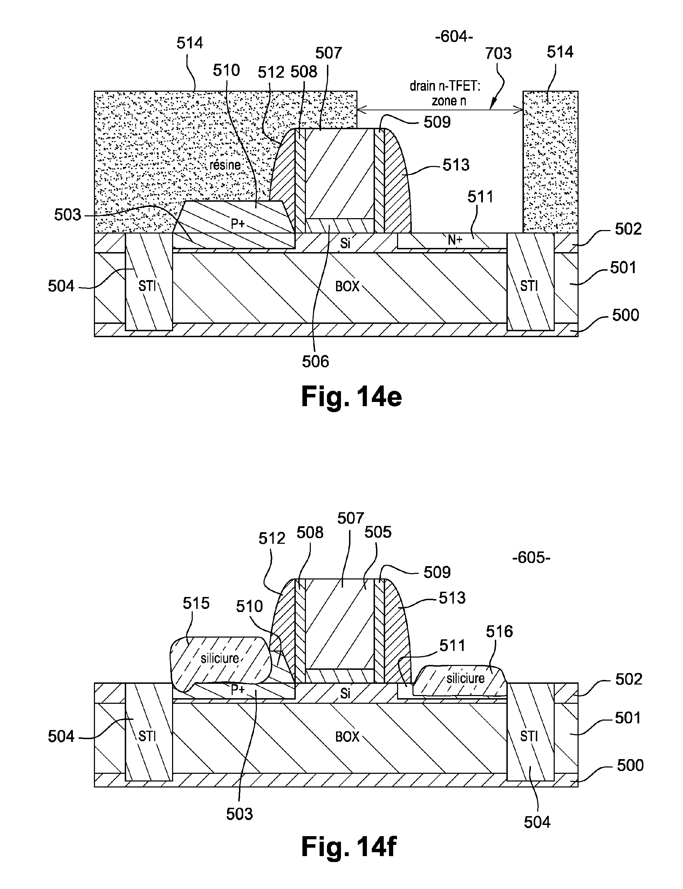

Selon l'étape 604 illustrée en figure 14e, on va réaliser le dopage N+ de la zone d'extension de drain 511. Ce dopage est réalisé en définissant tout d'abord un caisson de résine 514 dans lequel on ouvre la zone 703 à doper (l'ouverture est obtenue par lithographie et gravure). La zone ouverte est dopée N+ par implantation ionique (par exemple une implantation par des ions As ou P) de façon à obtenir la zone d'extension de drain 511 dopée. Contrairement à la zone d'extension de drain 511 de la figure 13h (première variante), la zone d'extension de drain 511 de la figure 14e n'est pas surélevée (i.e. le dopage N+ est fait directement dans la zone active). En outre, le fait d'avoir préalablement réalisé le second espaceur entraîne un décalage de la zone d'extension de drain 511 rendant le dispositif asymétrique : cette asymétrie réduit le caractère ambipolaire du dispositif ainsi que le courant à l'état bloqué.

Selon l'étape 605 illustrée en figure 14f, on finalise le dispositif selon l'invention ; pour ce faire, le caisson de résine 514 est retiré par une méthode de type « stripping » ou « lift-off ». On réalise ensuite un recuit d'implantation et on effectue également une étape de siliciuration de ces zones 515 et 516 ; la siliciuration correspond à la métallisation de ces zones. Le principal inconvénient de cette solution est qu'on ne dispose que d'une surface réduite pour effectuer la siliciuration côté drain.

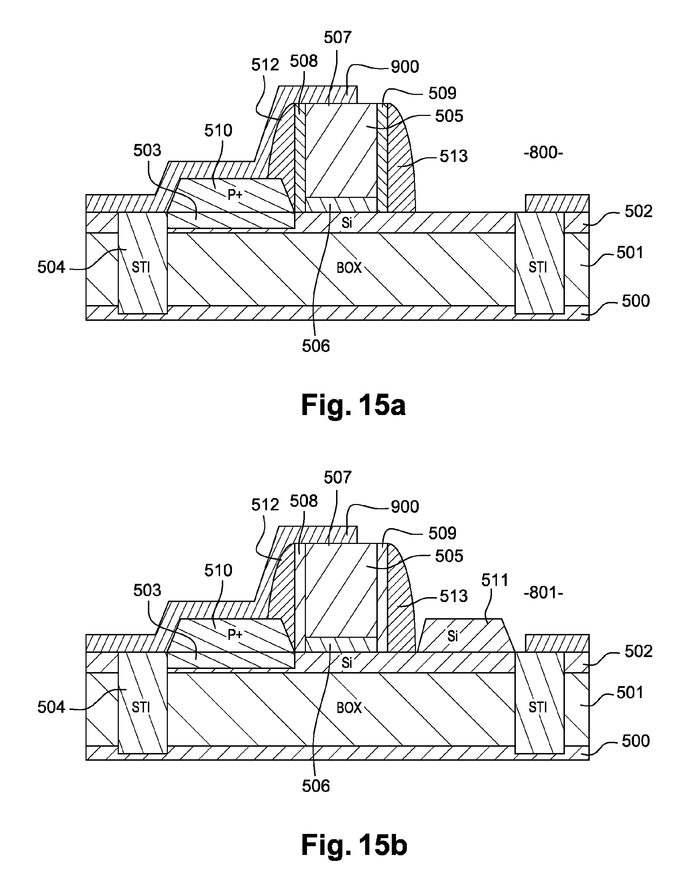

Les figures 15a à 15d illustrent les étapes d'un troisième mode de réalisation d'un procédé de fabrication d'un dispositif selon l'invention visant à résoudre le problème cité ci-dessus. Selon cette troisième variante de réalisation, on utilisera deux épitaxies : une première épitaxie pour la réalisation de la zone de source et une deuxième épitaxie pour la zone de drain. L'exemple est à nouveau celui d'un transistor TFET de type N.

Les premières étapes non représentées de cette troisième variante sont identiques aux étapes illustrées aux figures 13a à 13c puis aux étapes 14a à 14d.

Selon l'étape 800 représentée en figure 15a, on dépose un masque dur 800 recouvrant toute le dispositif à l'exception de la zone de drain où l'on va épitaxier une zone d'extension de drain surélevée. Pour ce faire, on dépose une couche de diélectrique (oxyde ou nitrure/oxyde) puis on réalise une lithographie et une gravure de la couche diélectrique pour ouvrir la couche 900 au niveau de la zone où l'on veut réaliser l'épitaxie.

Selon l'étape 801 illustrée en figure 15b, on réalise la région d'extension de drain 511 par épitaxie sélective d'un matériau semiconducteur (par exemple du Si non dopé ou du Si:C, l'implantation pour la réalisation du dopage N restant à faire).

L'épitaxie sélective permet notamment d'obtenir une épaisseur de la région d'extension de drain 511 supérieure à l'épaisseur du canal (i.e. épaisseur de la zone active 503).

Toutefois, contrairement au cas de la figure 13d, la région d'extension de drain 511 est réalisée indépendamment de la région d'extension de source 510 de sorte que les épaisseurs de ces régions 510 et 511 ne sont pas nécessairement identiques. De même, la région d'extension de drain est ici représentée avec des facettes mais ces dernières restent facultatives et sont pas nécessairement identiques aux facettes de la région d'extension de source formant un angle θ avec le premier espaceur 508. En d'autres termes, ce troisième mode de réalisation permet de relâcher considérablement les contraintes en séparant la réalisation des deux zones d'extension de drain et de source tout en permettant de surélever la zone d'extension de drain (et donc d'obtenir une zone de siliciuration plus importante).

On choisira l'épaisseur de la zone d'extension de drain 511 typiquement comprise entre 5 et 20nm.

On notera qu'il est également possible de réaliser directement le dopage de la zone d'extension de drain 511 en mettant en oeuvre une épitaxie dopée (ici par exemple une zone N+ avec du silicium ou du Si:C dopée in situ avec du P).

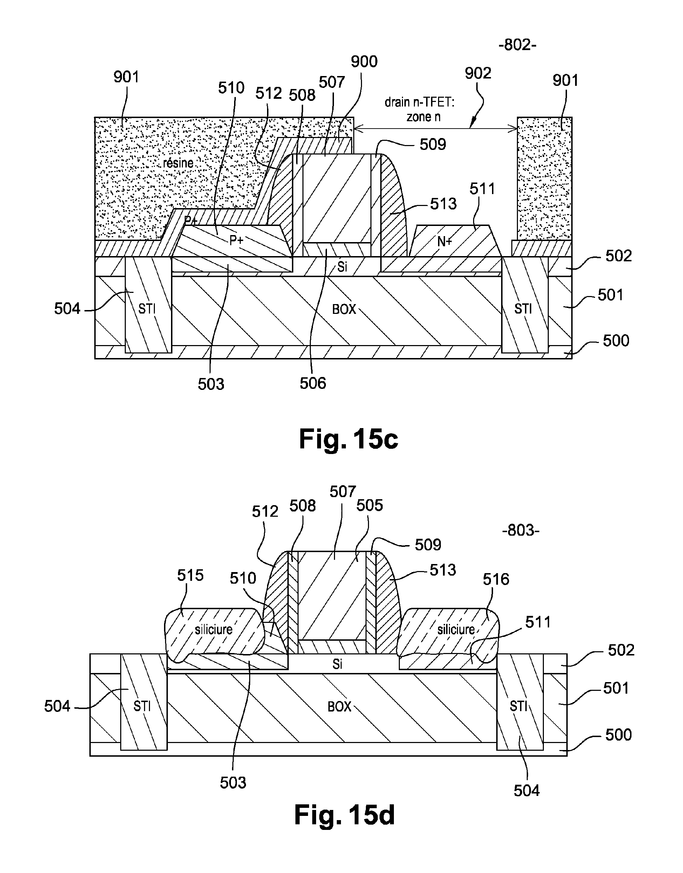

Selon l'étape 802 illustrée en figure 15c, on va réaliser le dopage N+ de la zone d'extension de drain 511. Ce dopage est réalisé en définissant tout d'abord un caisson de résine 901 dans lequel on ouvre la zone 902 à doper (l'ouverture est obtenue par lithographie et gravure). La zone ouverte est dopée N+ par implantation ionique (par exemple une implantation par des ions As ou P) de façon à obtenir la zone d'extension de drain 511 dopée. A nouveau, le fait d'avoir préalablement réalisé le second espaceur entraîne un décalage de la zone d'extension de drain 511 rendant le dispositif asymétrique : cette asymétrie réduit le caractère ambipolaire du dispositif ainsi que le courant à l'état bloqué.

Selon l'étape 803 illustrée en figure 15d, on finalise le dispositif selon l'invention ; pour ce faire, le caisson de résine 901 et le masque dur 900 sont retirés par une méthode de type « stripping » ou « lift-off ». Afin d'activer les atomes dopants et de guérir les défauts dus au bombardement, on réalise ensuite un recuit d'implantation (dit également recuit d'activation). Afin de minimiser la résistance des zones d'extension de drain 511 et de source 510 réalisées en silicium monocristallin dopé, on effectue également une étape de siliciuration de ces zones 515 et 516 ; la siliciuration correspond à la métallisation de ces zones.

L'invention trouve une application particulièrement intéressante dans le cas des applications de faible puissance ou l'électronique basse tension, par exemple dans le cas de la réalisation de mémoire statique SRAM (« Static Random Access Memory » en langue anglaise).

Bien entendu, le transistor selon l'invention n'est pas limité aux modes de réalisation qui viennent d'être décrits à titre indicatif et nullement limitatif en référence aux figures.

Ainsi, même si l'invention a été plus particulièrement décrite dans le cas d'un transistor à effet tunnel de type N, il est entendu qu'elle s'applique tout autant à un transistor à effet tunnel de type P en inversant le dopage P et N des régions semi-conductrices de source et de drain.

En outre, même si les différentes courbes présentées ont été obtenues pour des transistors à double grille, il est entendu que des résultats semblables sont obtenus pour un transistor selon l'invention à simple grille.

## Revendications

1. Transistor (100, 200) à effet tunnel comportant :
- un canal (101) réalisé dans un matériau semi-conducteur intrinsèque ;
- des régions d'extension de source (102) et de drain (103) de part et d'autre dudit canal (101), en contact avec le matériau semi-conducteur intrinsèque dudit canal (101), ladite région d'extension de source (102) étant réalisée dans un matériau semi-conducteur dopé selon un premier type de dopage P ou N et ladite région d'extension de drain (103) étant réalisée dans un matériau semi-conducteur dopé selon un second type de dopage inverse dudit premier type de dopage ;
- des régions conductrices de source (104) et de drain (105) respectivement en contact avec les régions d'extension de source (102) et de drain (103) et s'étendant respectivement au-dessus des régions d'extension de source (102) et de drain (103) ;
- une structure de grille (106) surmontant ledit canal (101) et agencée de sorte qu'une extrémité (109) dudit canal n'est pas recouverte par la structure de grille (106) du côté de la région d'extension de source (102), ladite structure de grille (106) comportant :
○ une couche diélectrique (108) de grille en contact avec ledit canal (101) ;
○ une zone de grille (107) au-dessus de ladite couche diélectrique (108) de grille de sorte que ladite couche diélectrique (108) de grille est disposée entre ladite zone de grille (107) et ledit canal (101) ;
- des moyens (110) pour former un espace isolant de drain entre les flancs respectifs de ladite structure de grille (106) et de ladite région conductrice de drain (105) en regard l'un de l'autre ;
- des moyens (111) pour former un espace isolant de source entre les flancs respectifs de ladite structure de grille (106) et ladite région conductrice de source (104) en regard l'un de l'autre, lesdits moyens comportant un premier (112) et un deuxième (113) espaceur diélectriques présentant chacun une première (116, 114) et une deuxième face latérale (115, 117) ;
ledit transistor (100, 200) étant **caractérisé en ce que** :
- ladite région d'extension de source (102) possède une épaisseur strictement (tS) supérieure à celle (tSi) du canal (101) de sorte que ladite région d'extension de source (102) présente une surépaisseur (118) en regard de ladite couche diélectrique (108) de grille ;
- la première face (116) dudit premier espaceur (112) est au contact du flanc de ladite zone de grille (107) suivi du flanc de ladite couche diélectrique (108) de grille de sorte que ladite première face (116) recouvre l'intégralité du flanc de ladite couche diélectrique (108) ;
- la deuxième face (115) dudit premier espaceur (112) est au contact de la première face (114) dudit deuxième espaceur (113) et se prolonge le long du flanc de la surépaisseur (118) de la région d'extension de source (102) ;
- le premier espaceur (112) recouvre la surface supérieure de l'extrémité (109) dudit canal (101) non recouverte par la structure de grille (106) et présente une longueur (1) strictement inférieure à 5nm, ladite longueur (1) étant mesurée selon la direction longitudinale (120) dudit canal (101).

2. Transistor selon la revendication précédente **caractérisé en ce que** ledit premier espaceur est réalisé dans un matériau diélectrique low-k et ladite couche diélectrique de grille est réalisée dans un matériau high-k.

3. Transistor selon la revendication précédente **caractérisé en ce que** ledit deuxième espaceur est réalisé dans un matériau diélectrique low-k.

4. Transistor selon l'une des revendications précédentes **caractérisé en ce que** la longueur dudit premier espaceur est comprise entre 1 et 4 nm.

5. Transistor selon la revendication précédente **caractérisé en ce que** la longueur dudit premier espaceur est comprise entre 1 et 2 nm.

6. Transistor selon l'une des revendications précédentes **caractérisé en ce que** ladite surépaisseur de ladite région d'extension de source est sensiblement égale à l'épaisseur de la couche diélectrique de grille.

7. Transistor selon l'une des revendications précédentes **caractérisé en ce que** ledit canal et ladite région d'extension de drain présentent la même épaisseur.

8. Transistor selon l'une des revendications précédentes **caractérisé en ce que** ladite région conductrice de drain recouvre intégralement la région d'extension de drain.

9. Transistor selon l'une des revendications précédentes **caractérisé en ce que** lesdits moyens pour former un espace isolant de drain entre les flancs respectifs de ladite structure de grille et de ladite région conductrice de drain en regard l'un de l'autre sont au contact dudit canal et s'étendent au-dessus de l'extrémité dudit canal du côté de la région d'extension de drain.

10. Transistor selon l'une des revendications précédentes **caractérisé en ce que** ledit transistor est un transistor à double grille présentant une structure symétrique au-dessus et au-dessous dudit canal prolongé de part et d'autre par les régions d'extension de source et de drain, ledit transistor comportant :
- des secondes régions conductrices de source et de drain respectivement en contact avec les régions d'extension de source et de drain et s'étendant respectivement au-dessous des régions d'extension de source et de drain ;
- une seconde structure de grille au-dessous dudit canal et agencée de sorte qu'une extrémité dudit canal n'est pas recouverte par la seconde structure de grille du côté de la région d'extension de source, ladite seconde structure de grille comportant :
○ une couche diélectrique de grille en contact avec ledit canal ;
○ une zone de grille au-dessous de ladite couche diélectrique de grille de sorte que ladite couche diélectrique de grille est disposée entre ladite zone de grille et ledit canal ;
- des moyens pour former un espace isolant de drain entre les flancs respectifs de ladite seconde structure de grille et de ladite seconde région conductrice de drain en regard l'un de l'autre ;
- des moyens pour former un espace isolant de source entre les flancs respectifs de ladite seconde structure de grille et ladite seconde région conductrice de source en regard l'un de l'autre, lesdits moyens comportant un premier et un deuxième espaceur diélectriques inférieurs présentant chacun une première et une deuxième face latérale ;
ladite région d'extension de source présentant une seconde surépaisseur en regard de ladite couche diélectrique de grille de ladite seconde structure de grille,
la première face dudit premier espaceur inférieur étant au contact du flanc de ladite zone de grille suivi du flanc de ladite couche diélectrique de grille de ladite seconde structure de grille de sorte que ladite première face recouvre l'intégralité du flanc de ladite couche diélectrique,
la deuxième face dudit premier espaceur inférieur étant au contact de la première face dudit deuxième espaceur inférieur et se prolonge le long du flanc de ladite seconde surépaisseur de la région d'extension de source,
le premier espaceur inférieur recouvrant la surface inférieure de l'extrémité dudit canal non recouverte par la seconde structure de grille et présentant une longueur strictement inférieure à 5nm, ladite longueur étant mesurée selon la direction longitudinale dudit canal.
